(19)

Europäisches
Patentamt
European
Patent Office
Office européen
des brevets

(11) **EP 4 610 671 A1**

(12) **EUROPEAN PATENT APPLICATION**

(43) Date of publication:
**03.09.2025 Bulletin 2025/36**

(21) Application number: **25160959.0**

(22) Date of filing: **28.02.2025**

(51) International Patent Classification (IPC):
***G01R 19/25*** (2006.01)

(52) Cooperative Patent Classification (CPC):
**G01R 19/2513; G01R 19/2506; G01R 31/086**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **28.02.2024 US 202418589825**

(71) Applicant: **Eaton Intelligent Power Limited
Dublin 4 (IE)**

(72) Inventor: **COX, Roger William
McDonald, 15057-2189 (US)**

(74) Representative: **Jolliffe, Jack Louis et al
Venner Shipley LLP
200 Aldersgate
London EC1A 4HD (GB)**

(54) **MEDIAN FILTER TO PREVENT SUB-CYCLE NUISANCE TRIGGERING IN AN ELECTRICAL POWER SYSTEM**

(57)     A power quality monitor for an electrical power system prevents nuisance alarms and unwanted masking of non-trivial voltage disturbances by employing median filtering of sampled voltage values while monitoring voltage conditions of the electrical power system.

**FIG. 1**

EP 4 610 671 A1

**Description**

FIELD OF THE INVENTION:

The disclosed concept relates generally to electrical power quality monitoring, and in particular, to detection of electrical disturbance events in electrical power distribution systems.

BACKGROUND OF THE INVENTION:

Power quality monitors are used to monitor voltage and current conditions in electrical power distribution systems in order to detect electrical irregularities. By continuously sampling voltage and current in a power distribution system, power quality monitors are typically able to detect significant issues fairly quickly and address their causes in a timely fashion, either automatically or by alerting personnel with an alarm. However, power quality monitors typically also often capture a variety of short-term disturbances such as transients, sags, swells and notching. Such short-term disturbances do not cause noticeable issues for the electrical power system and do not need to be addressed, as they resolve quickly on their own. Well-known examples of short-term voltage disturbances that are caused by routine activities in electrical power systems include transient overvoltages that arise due to capacitor switching and voltage sags that arise due to transformer energizing.

When short-term voltage disturbances cause a power quality monitor to issue an alarm, such an alarm is referred to as a nuisance alarm. It will be appreciated that nuisance alarms cause inefficiencies in power quality monitoring. Some known power quality monitors employ low-pass or averaging filters in order to prevent nuisance alarms, but such filters can lead to significant electrical events being undesirably masked, and can sometimes still be insufficient in preventing nuisance alarms.

There is thus room for improvement in the detection of electrical disturbance events, particularly in the area of transient detection.

SUMMARY OF THE INVENTION:

These needs, and others, are met by embodiments of a power quality monitor for use with electrical power systems that prevents nuisance alarms and unwanted masking of non-trivial voltage disturbances interrupter by employing median filtering of sampled voltage values while monitoring voltage conditions in an electrical power system.

In accordance with one aspect of the disclosed concept, a method for detecting voltage changes in an electrical power system comprises: providing a power quality monitor configured to monitor voltage levels in the electrical power system; choosing a filter window of size n with the power quality monitor; continuously sampling, with the power quality monitor, voltage of the electrical power system at a selected sampling rate such that a plurality of voltage samples are generated, with each voltage sample having a unique ordinal value; and designating one of the sampled voltage values to be a data point of interest $j_i$ and performing a filtering cycle with the power quality monitor. Performing the filtering cycle comprises: performing a median filtering operation for $j_i$ by applying the filter window to produce a median filtered voltage waveform; adding the median filtered voltage value to a median filtered voltage value; determining whether the median filtered voltage waveform meets any predetermined thresholds for a number of non-trivial voltage events; when the median filtered voltage waveform meets any of the predetermined thresholds, taking action to address the non-trivial voltage event; and when the median filtered voltage waveform does not meet any of the predetermined thresholds, designating one of the sampled voltage values having a higher ordinal value than $j_i$ to be a new data point of interest $j_i$ and performing the filtering cycle for the new data point of interest $j_i$.

In accordance with another aspect of the disclosed concept, a power quality monitor for an electrical power system comprises: a sampling device and a voltage event detector. The sampling device is configured to continuously sample voltage of the electrical power distribution system at a selected sampling rate in order to generate a plurality of voltage samples, with each voltage sample having a unique ordinal value. The voltage event detector is configured to designate one of the voltage samples to be a data point of interest $j_i$ and to perform a filtering cycle. The filtering cycle comprises: performing a median filtering operation for $j_i$ by applying the filter window to produce a median filtered voltage value; adding the median filtered voltage value to a median filtered voltage waveform; determining whether the median filtered waveform meets any predetermined thresholds for a number of non-trivial voltage events; when the median filtered voltage waveform meets any of the predetermined thresholds, taking corrective action to address the non-trivial voltage event; and when the median filtered voltage waveform does not meet any of the predetermined thresholds, designating one of the sampled voltage values having a higher ordinal value than $j_i$ to be a new data point of interest $j_i$ and performing the filtering cycle for the new data point of interest $j_i$.

BRIEF DESCRIPTION OF THE DRAWINGS:

A full understanding of the invention can be gained from the following description of the preferred embodiments when read in conjunction with the accompanying drawings in which:

FIG. 1 is a schematic diagram of a power quality monitor for monitoring an electrical power distribution system, in accordance with an example embodiment of the disclosed concept;
FIG. 2 is a waveform representative of a raw voltage signal produced by the electrical power distribution system of FIG. 1;
FIG. 3 is a waveform of a processed signal produced by median filtering the raw voltage signal of FIG. 2, using the power quality monitor of FIG. 1, in accordance with an example embodiment of the disclosed concept;
FIG. 4 is a waveform of a processed signal produced by average filtering the raw voltage signal of FIG. 2;
FIG. 5A is a waveform of a raw voltage signal with a sudden change in RMS;
FIG. 5B is a waveform of a processed signal produced by median filtering the raw voltage signal of FIG. 5A using the logic employed by the power quality monitor of FIG. 1, in accordance with an example embodiment of the disclosed concept;
FIG. 6 is a flow chart of a method for employing a median voltage filter to detect electrical disturbance events, in accordance with an example embodiment of the disclosed concept;
FIG. 7 is a waveform representative of another raw voltage signal produced by the electrical power distribution system of FIG. 1; and
FIG. 8 is an enlargement of a portion of the raw voltage waveform shown in FIG. 7, showing the raw voltage data points alongside median filtered data points produced in accordance with the method of FIG. 6.

DETAILED DESCRIPTION OF THE INVENTION:

Directional phrases used herein, such as, for example, left, right, front, back, top, bottom and derivatives thereof, relate to the orientation of the elements shown in the drawings and are not limiting upon the claims unless expressly recited therein.

As used herein, the singular form of "a", "an", and "the" include plural references unless the context clearly dictates otherwise.

As employed herein, the term "number" shall mean one or an integer greater than one (i.e., a plurality).

As employed herein, the term "processor" shall mean a programmable analog and/or digital device that can store, retrieve and process data; a controller; a control circuit; a computer; a workstation; a personal computer; a microprocessor; a microcontroller; a microcomputer; a central processing unit; a mainframe computer; a mini-computer; a server; a networked processor; or any suitable processing device or apparatus.

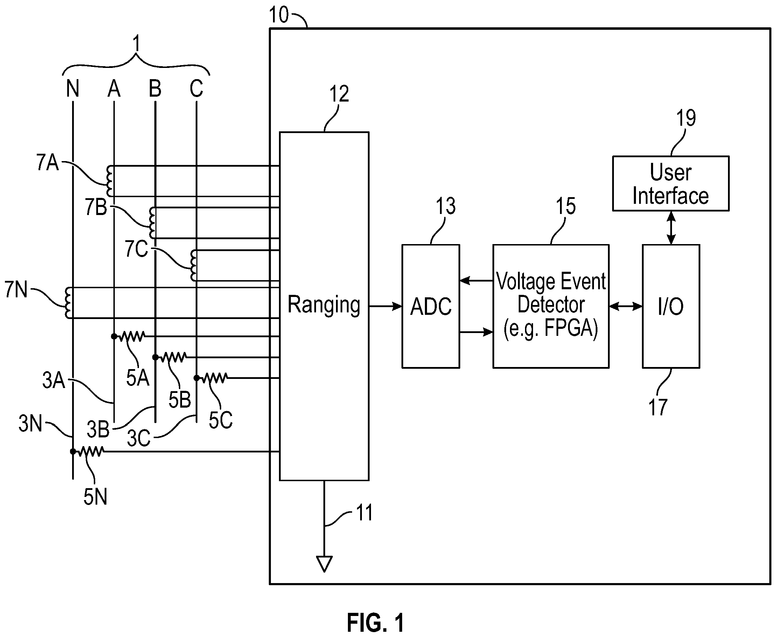

FIG. 1 is a schematic diagram of an electrical power system 1 and a power quality monitor 10 structured to monitor and analyze the electrical power system 1, in accordance with an example embodiment of the disclosed concept. The electrical power system 1 includes three phase conductors 3A, 3B, 3C, and a neutral conductor 3N; all of the conductors can be referred to generally and collectively or generally and individually with the reference number 3. The power quality monitor 10 includes a common/reference terminal 11 which is connected to ground. The electrical power system 1 includes four voltage sensors 5A, 5B, 5C, 5N configured to sense the three phase to ground voltages ($V_{AG}$, $V_{BG}$, $V_{CG}$) and the neutral to ground voltage ($V_{NG}$) in the electrical power system 1; all of the voltage sensors can be referred to generally and collectively or generally and individually with the reference number 5. As shown in FIG. 1, the voltage sensors 5 can comprise sensing resistors, for example and without limitation. The electrical power system 1 further includes current sensors 7A, 7B, 7C, 7N, configured to sense current flowing in the correspondingly labeled conductors; all of the current sensors can be referred to generally and collectively or generally and individually with the reference number 7. As shown in FIG. 1, the current sensors 7 can comprise current transformers, for example and without limitation.

The power quality monitor 10 includes a ranging circuit 12, a sampling device 13 comprising an ADC (analog to digital converter, referred to hereafter as the "ADC 13"), and a voltage event detector 15. The voltage event detector 15 can comprise any device suitable for executing logic operations, and in one non-limiting exemplary embodiment of the disclosed concept, the voltage event detector 15 comprises a FPGA (field-programmable gate array). It will be appreciated that ADCs are generally designed to accept voltage inputs of significantly less magnitude than the voltages found in power distribution systems such as the electrical power system 1. For example and without limitation, the ADC 13 can be rated to receive input as small as ±10V. As such, the ranging circuit 12 converts the voltages and currents sensed by the voltage sensors 5 and the current sensors 7 to smaller proportionate values appropriate for use with the input range of the ADC 13. The ADC 13 and the voltage event detector 15 are connected to provide input to one another. The voltage event detector 15 is configured to instruct the ADC 13 to sample analog signals from the electrical power system 1 at a specific sampling rate as detailed further later herein, the sampled analog signals corresponding to the phase voltages and currents sensed by the voltage sensors 5 and the current sensors 7.

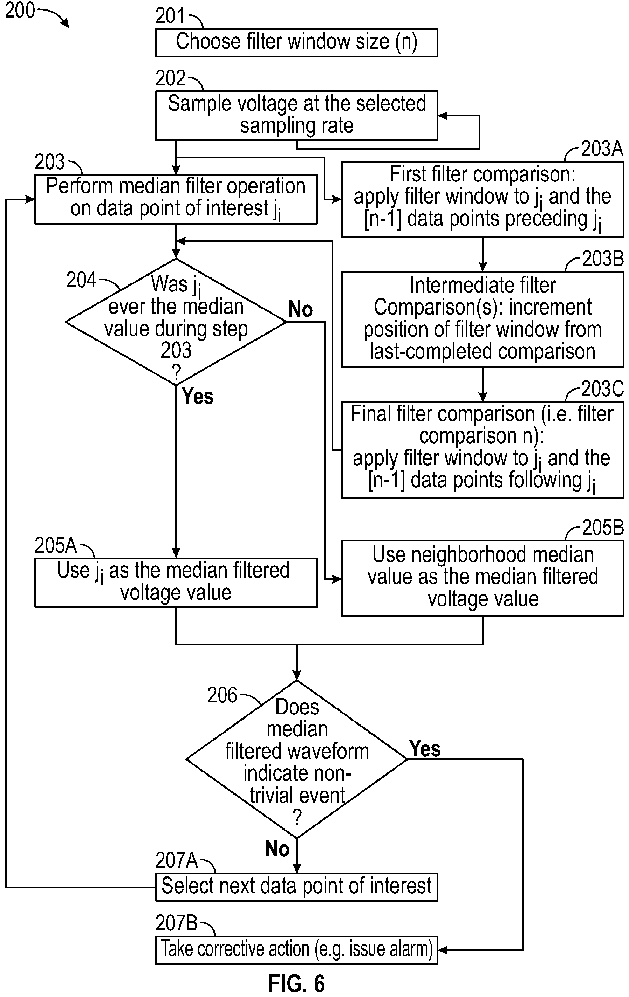

The voltage event detector 15 is configured to execute electrical disturbance detection functions using the inputs it receives from the ADC 13, as detailed further later herein in connection with the method 200 depicted in FIG. 6. The power quality monitor 10 further includes an I/O circuit 17 (input/output) and a user interface 19. The I/O circuit 17 is electrically connected between the voltage event detector 15 and the user interface 19. While not shown, it will be appreciated that the power quality monitor 10 is enclosed within a housing, and the user interface 19 can take any one of several forms that enables a user to provide input to the I/O circuit 17 and receive output from the I/O circuit 17. For example and without limitation, the user interface 19 can comprise a touchscreen on a front panel of the housing of the power quality monitor 10, a remote dashboard that communicates with the I/O circuit 17 via a communication link, or both. The I/O circuit 17 thus enables a user to provide inputs to control the electrical disturbance detection functions executed by the voltage event detector 15, and also enables the data output by the voltage event detector 15 to be readable by the user.

As used herein, the term "non-critical", when used to reference conditions that cause noticeable changes in the voltage level in the electrical power system 1, should be understood as describing conditions that are considered unlikely to lead to damage to or malfunctioning of the electrical power system 1 and any connected loads. Non-critical events are often referred to in the relevant technological field as "nuisance" events. It will be appreciated that non-critical conditions are typically considered non-critical because they are temporary (i.e. relatively short) in nature, and the term "temporary" is sometimes used herein in order to denote that a given voltage condition is non-critical. As previously noted, two well-known examples of temporary and non-critical conditions are transient overvoltages that arise due to capacitor switching and voltage sags that arise due to transformer energizing. Although such overvoltages and voltage sags can be significant in magnitude, such overvoltages and voltage sags are understood to be temporary for properly functioning electrical equipment. The power quality monitor 10 is thus configured (as detailed further herein) to allow for such temporary voltage disturbances, i.e. the power quality monitor 10 will not alert a user or take any corrective action in response to transient voltage irregularities in the electrical power system 1.

In contrast, as used herein, the term "non-trivial", when used to reference conditions that cause noticeable changes in the voltage level in the electrical power system 1, should be understood as describing conditions that are concerning and likely to lead to damage and/or malfunctioning of the electrical power system 1 and any connected loads, if allowed to persist. That is, the power quality monitor 10 is configured to alert a user and/or take corrective action if a non-trivial voltage disturbance is detected. It will be appreciated that non-trivial voltage disturbances typically are considered non-trivial due to being relatively sustained (i.e. non-temporary).

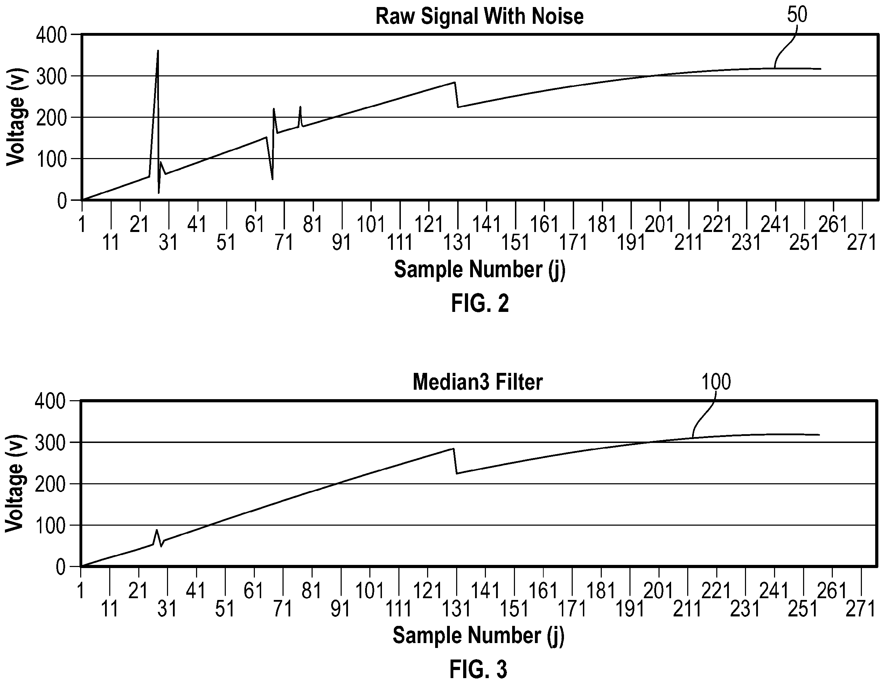

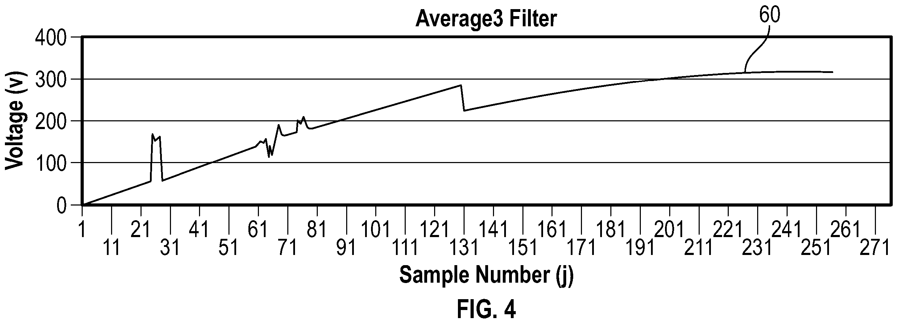

FIGS. 2-4 show waveforms of a raw voltage signal and two processed signals produced by applying two different filtering techniques to the raw voltage signal, in order to compare and contrast the advantages and disadvantages of different filtering techniques. FIG. 2 is a waveform representative of a raw voltage signal 50, showing voltage samples (also referred to hereinafter as "data points") from the electrical power system 1 captured by the ADC 13 via one of the voltage sensors 5. FIG. 3 is a waveform of a median filtered signal 100 produced by filtering the raw voltage signal 50 in the voltage event detector 15 of the power quality monitor 10, in accordance with an example embodiment of the disclosed concept and as detailed later herein in connection with a method 200 depicted in FIG. 6. FIG. 4 is a waveform of an average filtered signal 60 produced by filtering the raw voltage signal 50 with an averaging filter, as some known monitors for electrical power systems are known to do. In each of FIGS. 2-4, the x-axis of the graph corresponds to the ordinal value of each voltage sample captured by the ADC 13, and the y-axis corresponds to the voltage value of each voltage sample, in volts (V).

The regions of the raw signal waveform 50 (FIG. 2) showing noticeable changes in voltage have been analyzed in order to determine which regions are indicative of non-critical events and which regions are indicative of non-trivial events. In performing this analysis and determining which events from the raw signal waveform 50 are preserved or masked in the two processed waveforms 100 and 60, it has been determined that the median filtered waveform 100 produces a better capture of non-trivial voltage disturbances while removing all temporary irregularities that can be attributed to temporary/non-critical conditions relative to the average filtered waveform 60. In comparing the average filtered waveform 60 (FIG. 4) to the raw voltage waveform 50 (FIG. 2) and the median filtered waveform 100 (FIG. 3), it should be noted that applying an averaging filter to the raw voltage signal 50 results in voltage irregularities from temporary/non-critical conditions being unnecessarily preserved in the average filtered signal 60. That is, an averaging filter is typically overly sensitive to non-critical electrical events compared to the median filtering method 200 (FIG. 6) employed by the voltage event detector 15.

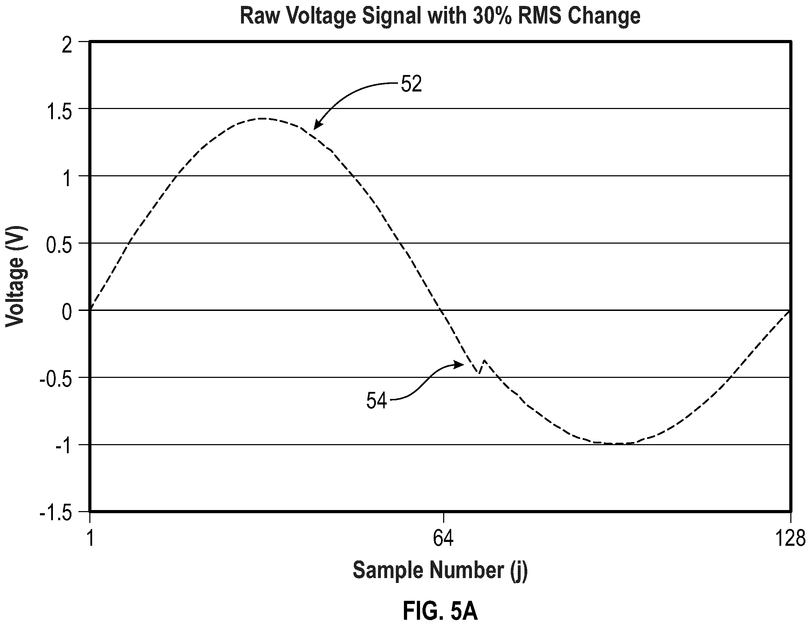

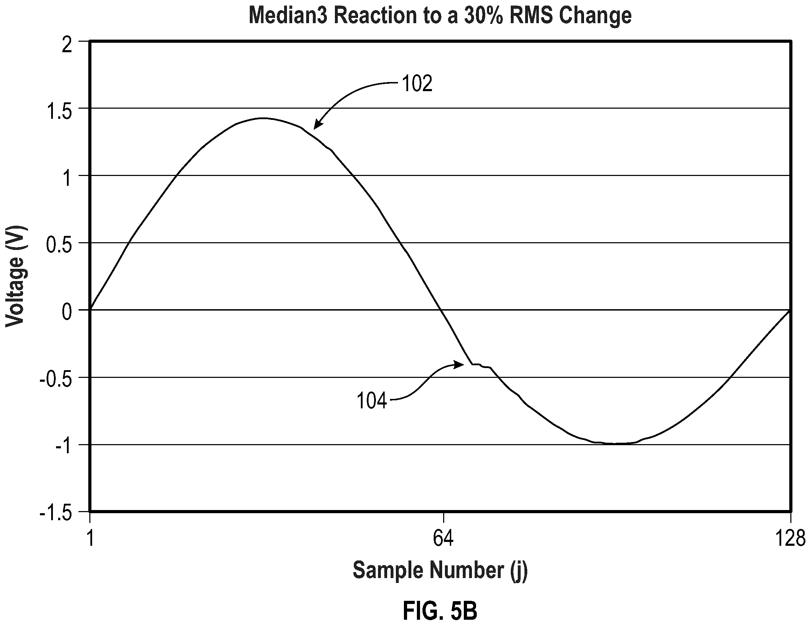

FIG. 5A shows a waveform of raw voltage signal 52 with a sudden RMS change, and FIG. 5B shows a waveform of a median filtered signal 102 produced by filtering the raw voltage signal 52 with the logic employed by the voltage event detector 15, in accordance with an example embodiment of the disclosed concept and as detailed further later in connection with the method 200 depicted in FIG. 6. As detailed further later herein, FIGS. 5A and 5B demonstrate that the logic employed by the voltage event detector 15 only minimally masks sudden RMS changes.

Referring now to FIG. 6, a flowchart of a method 200 for detecting voltage changes in an electrical power system is shown, in accordance with an exemplary embodiment of the disclosed concept. In particular, the method 200 detects non-trivial voltage events and suppresses non-critical voltage irregularities based on median filtering. The method 200 is employed, for example, by the power quality monitor 10 in order to detect electrical disturbance events in the electrical power system 1 shown in FIG. 1, and the method 200 is described in conjunction with the power quality monitor 10 and the electrical power system 1. However, it will be appreciated that the method may be employed by other devices and in other systems as well without departing from the scope of the disclosed concept.

At step 201, a filter window size for median filtering is selected (the filter window size being denoted by the variable 'n' herein). The power quality monitor 10 can be configured to allow a user to select a filter window size through the user interface 19, or the power quality monitor 10 can be configured to employ a predetermined optimal filter window size. The filter window size denotes the number of data points/voltage samples that are considered during a single filtering step. In an exemplary embodiment, the preferred size of the filter window is 3 data points, i.e. n = 3. A filter window of n = 3 is sufficiently large to provide meaningful filtering without making the logic so complex as to slow down the operation of the power quality monitor 10 to an adverse degree. For the sake of simplicity, the steps of the method 200 are explained using a filter window size of 3 samples, i.e. n = 3.

At step 202, the power quality monitor 10 continuously samples the voltage of the electrical power system 1. That is, the ADC 13 samples voltage from the voltage sensors 5 according to a predetermined sampling rate as instructed by the voltage event detector 15. The power quality monitor 10 can be configured to allow a user to select a the sampling rate through the user interface 19, or the power quality monitor 10 can be configured to employ a predetermined optimal sampling rate. It has been determined that the disclosed power monitoring device is most effective when the sampling rate is significantly higher than the fundamental AC line frequency (the fundamental AC line frequency for utility power in the U.S. being 60 Hz and the fundamental AC line frequency for mains power in several other countries being 50 Hz), and in an exemplary embodiment, a sampling rate of at least 128 samples/cycle is employed by the ADC 13. Each voltage value sampled by the ADC 13 is referred to herein as a "voltage sample", and each voltage sample has a unique ordinal value denoting when it was chronologically obtained relative to other voltage samples, i.e. first, second, third, etc.

Still referring to step 202, it will be appreciated that different users may want to employ different sampling rates, depending on the context in which a particular circuit breaker is being used. At higher sampling rates, there is a wider bandwidth for noise signals that are not of interest, while employing a lower sampling rate results in more high frequency noise appearing in the raw voltage waveform 50. However, a lower sampling rate also enables more complex sorting and/or filtering algorithms to be used. While any sampling rate can be chosen at step 202, it is noted that a relatively high sampling rate (1MHz, 10MHz) would need to be used in order to accurately detect transient events. Even though most users would not want the power quality monitor 10 to issue an alarm for a transient event, detecting and recording transient events is often desired for analysis purposes.

Continuing to refer to step 202, it is expected that most users of the power quality monitor 10 would want to use a sampling rate of 1MHz or 10MHz. At sampling rates that high, the voltage event detector 15 would need to comprise a FPGA rather than a digital signal processor (DSP), as commonly available DSPs are unable to filter sufficiently quickly in accordance with such high sampling rates. Assuming that the electrical power system 1 is supplying 60Hz utility power, a sampling rate of 1MHz results in 16,667 voltage samples being generated during one full voltage cycle of the power (1MHz sampling rate = $1 \times 10^6$ samples/sec; 60Hz power = 60 voltage cycles/sec; 1MHz sampling rate $\div$ 60Hz power = 16,667 samples/voltage cycle), and a sampling rate of 10MHz results in 166,667 voltage samples being generated during one full voltage cycle of the power (10MHz sampling rate = $1 \times 10^7$ samples/sec; 60Hz power = 60 voltage cycles/sec; 10MHz sampling rate $\div$ 60Hz power = 166,667 samples/voltage cycle).

At step 203, the voltage event detector 15 performs a median filtering operation for one data point of the raw voltage data waveform 50. The data point being median filtered at step 203 is referred to hereafter as the "data point of interest" and is denoted as $j_i$. During the median filtering operation, the voltage event detector 15 performs a plurality of comparisons (n comparisons, specifically) between $j_i$ and other data points from the raw voltage data waveform 50. Thus, step 203 is broken down into a series of n sub-steps (i.e. the total number of sub-steps corresponds to the filter window size n chosen at step 201), and with a unique filtering comparison being performed during each sub-step. That is, the processor performs a total of n comparisons at step 203. For n = 3, there are three sub-steps in step 203 such that the processor performs three comparisons during step 203. The same data point is the data point of interest for all of the sub-steps of step 203.

In FIG. 6, the sub-steps of step 203 are denoted as step 203A, step 203B, and step 203C. Step 203A is directed to the first filtering comparison, step 203C is directed to the final filtering comparison, and step 203B denotes all intermediate filtering comparisons that are performed between the first filtering comparison and the final filtering comparison. For n = 3, there are three total filtering comparisons performed, so the final filtering comparison is the third filtering comparison, and there is only one intermediate filtering comparison performed at step 203B, the intermediate filtering comparison being the second filtering comparison. More intermediate filtering comparisons would be performed at step 203B for larger filter windows (n > 3).

Continuing to refer to step 203, each voltage sample that makes up the raw voltage signal 50 can be referred to as $j_x$ (with 'x' being an ordinal value indicator), such that the first voltage sample is $j_1$, the second voltage sample is $j_2$, the third

voltage sample is $j_3$, etc. For a filter window size of size n, the $n^{th}$ data point ($j_n$) of the raw voltage signal 50 is the first data point of interest ($j_i$) for which median filtering is performed. So, for n = 3, median filtering is performed starting with the third data point, $j_3$, sampled by the ADC 13 ($j_n = j_3$). That is, $j_3$ is the data point of interest $j_i$ for the first filtering operation performed.

During each filtering comparison performed at each of steps 203A, 203B, and 203C, n data points are compared. Specifically, $j_i$ and [n-1] other data points are compared during each filtering comparison. Thus, for n = 3, three data points are compared in each filtering comparison, with the three data points being $j_i$ and two other data points. For the first filtering comparison performed at step 203A, $j_i$ is the last data point in the filtering window, and for the final filtering comparison performed at step 203C, $j_i$ is the first data point in the filtering window. Each time a filtering comparison (i.e. a single sub-step of step 203) is completed, the position of the filtering window is incremented by one data point/one voltage sample in order to perform the next subsequent filtering comparison. So, when n=3 and $j_3$ is the data point of interest: the data points $j_1, j_2, j_3$, are in the filtering window during the first filtering comparison performed at step 203A; the data points $j_2, j_3, j_4$, are in the filtering window during the second/intermediate filtering comparison performed at step 203B; and the data points $j_3, j_4, j_5$, are in the filtering window during the third/final filtering comparison performed at step 203C. That is, the median value among data points $j_1$-$j_3$ is identified at step 203A, the median value among data points $j_2$-$j_4$ is identified at step 203B, and the median value among data points $j_3$-$j_5$ is identified at step 203C.

The utility of using n=3 (as opposed to n>3) becomes especially apparent when considering all of the processing steps that must be performed during each sub-step of step 203. The following high-level code, referred to hereafter as Median3, represents the code executed by the voltage event detector 15 during each sub-step of step 203 in order to determine the median value from among three data points at each sub-step, enabling the voltage event detector 15 to successfully perform method 200 when voltages $V_{AG}$, $V_{BG}$, $V_{CG}$ and $V_{NG}$ of the electrical power system 1 are being sampled at rates as high as 10MHz (10 million samples per second) (a, b, and c used below represent the three most-recent voltage samples):

```
{
  if(a>b) {if(b>c) {return b;} else if(a>c) {return c;}else{return a;} }
  else {if(a>c) {return a;} else if(b>c) {return c;} else {return b;}}
}
```

The Median3 logic shows that finding the median value among three data points is especially simple and inexpensive in terms of processing resources, but it can be appreciated that increasing the filter window n by even one data point significantly increases the processing resources required to perform each sub-step of step 203. The following summation equation and Table 1 below demonstrate how quickly the number of comparisons/sub-steps grows at step 203 for filter windows greater than 3 (n>3):

$$Comparisons = \sum_{k=2}^{n}(k-1)$$

**Table 1**

| Window size (n) | Number of Comparisons Required | Samples in Window | Comparisons Performed |
|---|---|---|---|
| n=3 | 3 | A, B, C | AB, AC, BC |
| n=5 | 10 | A, B, C, D, E | AB, AC, AD, AE, BC, BD, BE, CD, CE, DE |
| n=7 | 21 | A, B, C, D, E, F, G | AB, AC, AD, AE, AF, AG, BC, BD, BE, BF, BG, CD, CE, CF, CG, DE, DF, DG, EF, EG, FG |

Another special characteristic of using n=3 (and consequently using Median3) is that for an AC waveform, the Median3 logic has zero effect on a sinewave as it is rising and falling, and it has only a negligible side effect at the peaks, despite the small number of samples (3) being filtered. As a result, Median3 can filter errors and discontinuities without reducing accuracy for calculations on sinusoidal data.

Continuing to refer to the advantages of using n=3 and of using the Median3 logic at step 203, reference is made once more to FIGS. 5A and 5B. As previously noted, FIG. 5A shows a raw AC waveform 52 with a sudden RMS change of about 30%, and FIG. 5B shows a median filtered waveform 102 produced by applying Median3 to the raw AC waveform 52 of FIG. 5A. The waveform of the median filtered signal 102 is nearly identical to the waveform of the raw voltage signal 52, except for in the region 104 of the median filtered waveform 102, which corresponds to the region 54 of the raw voltage waveform 52. The region 54 of the raw voltage waveform 52 is where the RMS change occurs. The raw voltage signal 52 was obtained with a sampling rate of 128 samples/cycle, and exhibits an approximate 30% reduction in the RMS level shortly after the $64^{th}$ sample, changing the relative peak of the signal from 1.4V to 1.0V. As a result, the raw voltage waveform 52 has a discontinuity in the region 54, and the Median3 filter interprets the waveform 52 as having two erroneous samples that get substituted in the region 104 of the filtered waveform 102 with the value of the most-recent sample preceding the two erroneous samples. Even though the median filter technically masks the discontinuity when the change in RMS occurs, the effect of masking is negligible, since the change in RMS is otherwise easy to perceive and is still denoted by the flattened region 104 of the filtered waveform 102 that coincides with the region of discontinuity 54 in the raw waveform 52. It should be noted that using a filter window of n>3 would still result in the two samples at the discontinuity being deemed erroneous by a median filter. In addition, as previously stated, the Median3 filter has only a negligible side effect at the peaks of a sinusoidal AC waveform and changes no data while the waveform is rising or falling. That is, the ability of the Median3 filter to quickly and effectively filter non-critical irregularities (e.g. as demonstrated by the waveform 100 in FIG. 3) and preserve the data around the peaks of a sinusoidal AC waveform far outweighs the negligible effect of masking discontinuities arising from RMS changes.

After the median value is determined in each of sub-steps 203A-203C, the voltage event detector 15 determines at step 204 whether $j_i$ was the median value in any of the comparisons performed during the sub-steps of step 203. If $j_i$ was the median value in any of the comparisons performed at steps 203A-203C, then $j_i$ is deemed to be the median filtered voltage value of the median filtering operation performed at step 203 and is added as a data point to the median filtered waveform 100 at step 205A. However, if $j_i$ was not the median value in any of the comparisons performed at steps 203A-203C, then one of the neighbor data points that $j_i$ was compared to during step 203 will be deemed to be the median filtered voltage value of the median filtering operation performed at step 203 and will be added as a data point to the median filtered waveform 100 at step 205B. Each of steps 205A and 205B can be referred to generally as step 205, and step 205 can be generally referred to as determining the median filtered voltage value. When the method has to progress to step 205B instead of step 205A, the median filtered voltage value is determined by finding the neighborhood median value, which is determined by comparing all of the $j_i$ neighbor data points evaluated during all of the sub-steps of step 203, and finding the median value among all of those $j_i$ neighbor data points. It will be appreciated that the median filter operation is performed at step 203 in order to determine the quality of the data point of interest, as the median filter operation can identify a data point of interest that is a clear outlier relative to other neighboring data points.

Applying steps 204-205 to the example where $j_3$ is the data point of interest $j_i$ and the filter window is three data points (n=3), it is noted that data points $j_1$ - $j_5$ are all of the data points considered during all of the comparisons performed during step 203, as $j_1$ is the first data point in the first filtering comparison 203A and $j_5$ is the last data point in the last filtering comparison 203C. If it is found at step 204 that $j_3$ was the median value in any of the comparisons performed at steps 203A-203C, then $j_3$ is deemed to be the median filtered voltage value for the median filtering operation and is added to the median filtered waveform 100 at step 205A. However, if it is found at step 204 that $j_3$ was not the median value in any of the comparisons performed at steps 203A-203C, then a neighborhood median value is found at step 205B by determining which of the other neighbor data points ($j_1$, $j_2$, $j_4$, and $j_5$) is the median value for the data set $j_1$ - $j_5$, and the neighborhood median value is deemed to be the median filtered voltage value for the median filtering operation and is added to the median filtered waveform 100 instead of the data point of interest $j_3$.

The power quality monitor 10 is configured to identify a number of voltage conditions indicative of non-trivial electrical disturbances. After step 205A or 205B is performed, the voltage event detector 15 determines at step 206 whether the median filtered waveform 100 meets any predetermined thresholds or criteria indicative of a non-trivial electrical event. For example and without limitation, the power quality monitor 10 can be programmed to determine that a non-trivial event is occurring when any of the following conditions are met: (1) the magnitudes of a series of voltage values in the median filtered waveform 100 exceed a predetermined threshold maximum voltage (indicative of voltage swell or overvoltage), (2) the magnitudes of a series of voltage values in the median filtered waveform 100 are less than a predetermined threshold minimum voltage (indicative of voltage sag), or (3) when a rate of rise in the magnitude of a series of voltage values in the median filtered waveform 100 exceeds a predetermined acceptable rate of rise (dv/dt). If it is determined that there is no non-trivial event occurring, the method proceeds to step 207A, where a new data point of interest $j_i$ is selected, as detailed further below. If, however, it is determined that there is a non-trivial event occurring, then the method proceeds to step 207B, where corrective action is taken. It will be appreciated that the particular corrective action(s) taken at step 207B will vary depending on the particular application of the specific electrical power system being monitored, but one non-limiting example of such corrective action is to issue an alarm to a user of the electrical power system. Each of steps 207A and 207B can be referred to generally as step 207.

At step 207A, a new data point of interest $j_i$ is selected. In one non-limiting embodiment, the data point with the next highest ordinal value relative to the current data point of interest $j_i$ (i.e. the voltage sample that chronologically follows the current data point of interest $j_i$) is selected as the new data point of interest. The method then returns to step 203 so that the median filtering operation can be performed on the new data point of interest $j_i$ chosen at step 207A. So in the example detailed above where $j_3$ was the first data point of interest $j_i$ during steps 203-206, $j_4$ would be the new data point of interest $j_i$ selected at step 207A and steps 203-207 would be repeated using $j_4$ as $j_i$ instead of $j_3$.

Steps 203-207 can be referred to as a filtering cycle and are repeated until median filtering is no longer needed. For example and without limitation, if the method proceeds from step 206 to step 207B due to the detection of a non-trivial event or the electrical power system 1 is otherwise powered down, then the method 200 will cease. In addition, as previously stated, the voltage of the electrical power system 1 is continuously sampled at step 202, such that step 202 is continuously performed simultaneously during the cyclical iterations of steps 203-207. It will be appreciated that each iteration of step 203 is performed on a slight delay relative to step 202, as enough voltage data points have to have been sampled at step 202 in order to perform all of the sub-steps of step 203 during a given iteration of step 203.

Reference is made again briefly again to FIG. 4 in conjunction with FIGS. 2-3, in order to contrast the method of median filtering with average filtering. When an averaging filter is applied to a raw voltage signal (such as the raw voltage signal 50) in order to produce a waveform such as the average filtered signal waveform 60, the process is similar to that described in conjunction with method 200, except that each data point of interest is averaged with the other data points in the filtering window rather than compared for the purpose of finding the median value. Finding the average value instead of finding the median value will lead to nuisance alarms being triggered more often by a power quality monitor, particularly with respect to temporary voltage irregularities. This is because outlier voltage samples whose magnitudes differ significantly from other nearby voltage values will skew the nearby voltage values during generation of the average filtered waveform 60, even when the outlier values are temporary compared to the nearby values.

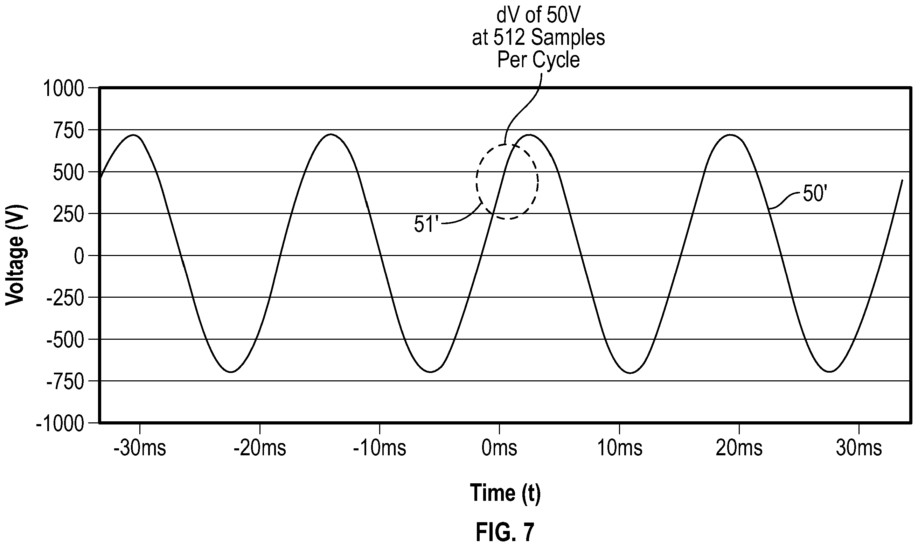

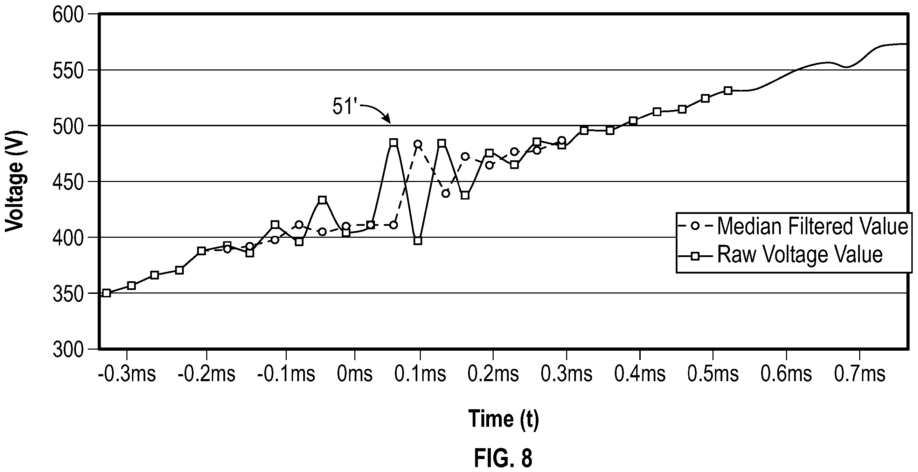

In FIG. 7, another raw voltage signal 50' is shown, and a selected portion 51' of the raw voltage signal 50' (indicated by the circle in FIG. 7) is shown on an enlarged scale in FIG. 8. In FIG. 8, the raw voltage data points from the selected portion 51' of the raw voltage signal 50' are shown alongside median filtered data points produced by applying the method 200 to the selected portion 51' of the raw voltage signal 50'. In reviewing the selected portion 51' in FIG. 8, it can be seen that the median filtering method 200 smooths the raw voltage data without masking the most pronounced voltage changes in the raw voltage data.

As previously stated, in response to the voltage event detector 15 detecting an electrical disturbance, the power quality monitor 10 can take some corrective action such as triggering an alarm to a user through the user interface 19. It should be appreciated from the discussion of the waveforms 50, 100, 60, 52, 102, and 50' shown in FIGS. 2-5B and 7-8 that the median filtering method 200 employed by the power quality monitor 10 advantageously masks temporary/non-critical voltage disturbances while preserving and timestamping non-trivial voltage disturbances, so that corrective action will only be taken in response to electrical disturbances expected to cause adverse effects (i.e. not in response to nuisance events or negligible discontinuities), and that the median filtering method 200 filters errors and discontinuities from a raw voltage signal without reducing accuracy for calculations on sinusoidal data. As stated in connection with step 202 of the method 200, it is expected that most users of the power quality monitor 10 would want to use sampling rates of 1MHz or 10MHz. However, it is worth noting that the method 200 is still effective at eliminating single-sample noise even when relatively low sampling rates (e.g. 32 samples per cycle, 128 samples per cycle, 512 samples per cycle) are used.

While specific embodiments of the invention have been described in detail, it will be appreciated by those skilled in the art that various modifications and alternatives to those details could be developed in light of the overall teachings of the disclosure. Accordingly, the particular arrangements disclosed are meant to be illustrative only and not limiting as to the scope of disclosed concept which is to be given the full breadth of the claims appended and any and all equivalents thereof.

**Claims**

1. A method for detecting voltage changes in an electrical power system, the method comprising:

    providing a power quality monitor configured to monitor voltage levels in the electrical power system;
    choosing a filter window of size n with the power quality monitor;
    continuously sampling, with the power quality monitor, voltage of the electrical power system at a selected sampling rate such that a plurality of voltage samples are generated, with each voltage sample having a unique ordinal value; and
    designating one of the voltage samples to be a data point of interest $j_i$ and performing a filtering cycle with the power quality monitor, wherein performing the filtering cycle comprises:

        performing a median filtering operation for $j_i$ by applying the filter window to produce a median filtered voltage value;

adding the median filtered voltage value to a median filtered voltage waveform;
determining whether the median filtered voltage waveform meets any predetermined thresholds indicative of a number of non-trivial voltage events;
when the median filtered voltage waveform meets any of the predetermined thresholds, taking action to address the non-trivial voltage event; and
when the median filtered voltage waveform does not meet any of the predetermined thresholds, designating one of the sampled voltage values having a higher ordinal value than $j_i$ to be a new data point of interest $j_i$ and performing the filtering cycle for the new data point of interest $j_i$.

2. The method of claim 1,

wherein n=3,
wherein performing the median filtering operation comprises performing three filtering comparisons,
wherein, during each filtering comparison, $j_i$ and two other voltage samples fall within the filtering window and a median value is identified among $j_i$ and the two other voltage samples,
wherein, when $j_i$ is identified as the median value for at least one of the filtering comparisons, the median filtered voltage value for the median filtering operation is $j_i$, and
wherein, when $j_j$ is not identified as the median value for any of the filtering comparisons, a neighborhood median value is identified from all of the other voltage samples to which $j_i$ was compared during the three filtering comparisons, and the median filtered voltage value for the median filtering operation is the neighborhood median value.

3. The method of claim 2,

wherein the three filtering comparisons include a first filtering comparison, a second filtering comparison, and a third filtering comparison,
wherein $j_i$ is compared to the two voltage samples immediately preceding $j_i$ during the first filtering comparison,
wherein $j_i$ is compared to the one voltage sample immediately preceding $j_i$ and to the one voltage sample immediately following $j_i$ during the second filtering comparison, and
wherein $j_i$ is compared to the two voltage samples immediately following $j_i$ during the third filtering comparison.

4. The method of any preceding claim,

wherein the power quality monitor comprises a field-programmable gate array, FPGA, and
wherein the filtering cycle is performed by the FPGA.

5. The method of any preceding claim,

wherein n>3,
wherein performing the median filtering operation comprises performing n filtering comparisons,
wherein, during each filtering comparison, $j_i$ and [n-1] other voltage samples fall within the filtering window and a median value is identified among $j_i$ and the [n-1] other voltage samples,
wherein, when $j_i$ is identified as the median value for at least one of the filtering comparisons, the median filtered voltage value for the median filtering operation is $j_i$, and
wherein, when $j_j$ is not identified as the median value for any of the filtering comparisons, a neighborhood median value is identified from all of the other voltage samples to which $j_i$ was compared during the n filtering comparisons, and the median filtered voltage value for the median filtering operation is the neighborhood median value.

6. The method of claim 5,

wherein the n filtering comparisons include a first filtering comparison, a plurality of intermediate comparisons, and a final filtering comparison,
wherein $j_i$ is compared to the [n-1] voltage samples immediately preceding $j_i$ during the first filtering comparison,
wherein, for each intermediate filtering comparison, the filtering window is incremented by one voltage sample relative to the immediately preceding filtering comparison, and
wherein $j_i$ is compared to the [n-1] voltage samples immediately following $j_i$ during the final filtering comparison.

7. A power quality monitor for an electrical power system, the power quality monitor comprising:

a sampling device configured to continuously sample voltage of the electrical power system at a selected sampling rate in order to generate a plurality of voltage samples, with each voltage sample having a unique ordinal value; and

a voltage event detector,

wherein the voltage event detector is configured to designate one of the voltage samples to be a data point of interest $j_i$ and to perform a filtering cycle, the filtering cycle comprising:

> performing a median filtering operation for $j_i$ by applying the filter window to produce a median filtered voltage value;
>
> adding the median filtered voltage value to a median filtered voltage waveform;
>
> determining whether the median filtered voltage waveform meets any predetermined thresholds indicative of a number of non-trivial voltage events;
>
> when the median filtered voltage waveform meets any of the predetermined thresholds, taking corrective action to address the non-trivial voltage event; and
>
> when the median filtered voltage waveform does not meet any of the predetermined thresholds, designating one of the sampled voltage values having a higher ordinal value than $j_i$ to be a new data point of interest $j_i$ and performing the filtering cycle for the new data point of interest $j_i$.

8. The power quality monitor of claim 7,

wherein n=3,

wherein performing the median filtering operation comprises performing three filtering comparisons,

wherein, during each filtering comparison, $j_i$ and two other voltage samples fall within the filtering window and a median value is identified among $j_i$ and the two other voltage samples,

wherein, when $j_i$ is identified as the median value for at least one of the filtering comparisons, the median filtered voltage value for the median filtering operation is $j_i$, and

wherein, when $j_i$ is not identified as the median value for any of the filtering comparisons, a neighborhood median value is identified from all of the other voltage samples to which $j_i$ was compared during the three filtering comparisons, and the median filtered voltage value for the median filtering operation is the neighborhood median value.

9. The power quality monitor of claim 8,

wherein the three filtering comparisons include a first filtering comparison, a second filtering comparison, and a third filtering comparison,

wherein $j_i$ is compared to the two voltage samples immediately preceding $j_i$ during the first filtering comparison,

wherein $j_i$ is compared to the one voltage sample immediately preceding $j_i$ and to the one voltage sample immediately following $j_i$ during the second filtering comparison, and

wherein $j_i$ is compared to the two voltage samples immediately following $j_i$ during the third filtering comparison.

10. The power quality monitor of any of claims 7 to 9,

wherein the power quality monitor comprises a field-programmable gate array, FPGA, and

wherein the filtering cycle is performed by the FPGA.

11. The power quality monitor of any of claims 7 to 10,

wherein n>3,

wherein performing the median filtering operation comprises performing n filtering comparisons,

wherein, during each filtering comparison, $j_i$ and [n-1] other voltage samples fall within the filtering window and a median value is identified among $j_i$ and the [n-1] other voltage samples,

wherein, when $j_i$ is identified as the median value for at least one of the filtering comparisons, the median filtered voltage value for the median filtering operation is $j_i$, and

wherein, when $j_i$ is not identified as the median value for any of the filtering comparisons, a neighborhood median value is identified from all of the other voltage samples to which $j_i$ was compared during the n filtering comparisons, and the median filtered voltage value for the median filtering operation is the neighborhood median value.

12. The method of claim 11,

wherein the n filtering comparisons include a first filtering comparison, a plurality of intermediate comparisons, and a final filtering comparison,

wherein $j_i$ is compared to the [n-1] voltage samples immediately preceding $j_i$ during the first filtering comparison,

wherein, for each intermediate filtering comparison, the filtering window is incremented by one voltage sample relative to the immediately preceding filtering comparison, and

wherein $j_i$ is compared to the [n-1] voltage samples immediately following $j_i$ during the final filtering comparison.

**FIG. 1**

Raw Signal With Noise

50

FIG. 2

EP 4 610 671 A1

Median3 Filter

100

FIG. 3

FIG. 4

EP 4 610 671 A1

Raw Voltage Signal with 30% RMS Change

Voltage (V)

Sample Number (j)

FIG. 5A

EP 4 610 671 A1

Median3 Reaction to a 30% RMS Change

FIG. 5B

200 —↘

201 —↘
Choose filter window size (n)

202 —↘
Sample voltage at the selected sampling rate

203 —↘
Perform median filter operation on data point of interest $j_i$

203A
First filter comparison: apply filter window to $j_i$ and the [n-1] data points preceding $j_i$

203B
Intermediate filter Comparison(s): increment position of filter window from last-completed comparison

203C
Final filter comparison (i.e. filter comparison n): apply filter window to $j_i$ and the [n-1] data points following $j_i$

204 —↘
Was $j_i$ ever the median value during step 203 ?

No

Yes

205A —↘
Use $j_i$ as the median filtered voltage value

205B
Use neighborhood median value as the median filtered voltage value

206 —↘
Does median filtered waveform indicate non-trivial event ?

Yes

No

207A —↘
Select next data point of interest

207B —↘
Take corrective action (e.g. issue alarm)

**FIG. 6**

FIG. 7

EP 4 610 671 A1

FIG. 8

EP 4 610 671 A1

| | Europäisches Patentamt / European Patent Office / Office européen des brevets | **EUROPEAN SEARCH REPORT** | | **Application Number** EP 25 16 0959 |
|---|---|---|---|---|

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | BASTOS ALVARO FURLANI ET AL: "Novel Moving Average Filter for Detecting RMS Voltage Step Changes in Triggerless PQ Data", IEEE TRANSACTIONS ON POWER DELIVERY, IEEE SERVICE CENTER, NEW YORK, NY, US, vol. 33, no. 6, 1 December 2018 (2018-12-01), pages 2920-2929, XP011697819, ISSN: 0885-8977, DOI: 10.1109/TPWRD.2018.2831183 [retrieved on 2018-11-19] | 1,4,7,10 | INV. G01R19/25 |
| A | * the whole document * | 2,3,5,6, 8,9,11, 12 | |
| | ----- | | |
| A | FURLANI BASTOS ALVARO ET AL: "Detection of inconspicuous power quality disturbances through step changes in rms voltage profile", IET GENERATION, TRANSMISSION&DISTRIBUTION, IET, UK, vol. 13, no. 11, 4 June 2019 (2019-06-04), pages 2226-2235, XP006080453, ISSN: 1751-8687, DOI: 10.1049/IET-GTD.2018.6511 * the whole document * | 1-12 | |
| | ----- | | **TECHNICAL FIELDS SEARCHED (IPC)** G01R |
| | -/-- | | |

The present search report has been drawn up for all claims

| Place of search | Date of completion of the search | Examiner |
|---|---|---|
| Munich | 25 July 2025 | Bergado Colina, J |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

page 1 of 3

Europäisches
Patentamt

European
Patent Office

Office européen
des brevets

**EUROPEAN SEARCH REPORT**

Application Number

EP 25 16 0959

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | AHMAD TABIA ET AL: "Statistical Characterization of PMU Error for Robust WAMS Based Analytics", IEEE TRANSACTIONS ON POWER SYSTEMS, IEEE, USA, vol. 35, no. 2, 2 September 2019 (2019-09-02), pages 920-928, XP011772499, ISSN: 0885-8950, DOI: 10.1109/TPWRS.2019.2939098 [retrieved on 2020-02-18] * the whole document * | 1-12 | |
| A | CN 116 908 569 A (GUIZHOU POWER GRID CO LTD) 20 October 2023 (2023-10-20) * the whole document * | 1-12 | |
| A | CN 103 439 569 B (JIANGSU LINYANG ELECTRONICS CO ET AL.) 20 January 2016 (2016-01-20) * the whole document * | 1-12 | |
| A | CN 113 030 616 A (STATE GRID FUJIAN ELECTRIC POWER CO ET AL.) 25 June 2021 (2021-06-25) * the whole document * | 1-12 | TECHNICAL FIELDS SEARCHED (IPC) |
| A | CN 106 443 164 B (CHINA ELECTRIC POWER RES INST; STATE GRID CORP CHINA) 29 November 2019 (2019-11-29) * the whole document * | 1-12 | |
| A | CN 107 462 764 A (NANJING CANNENG ELECTRIC POWER AUTOMATION CO LTD) 12 December 2017 (2017-12-12) * the whole document * | 1-12 | |

-/--

The present search report has been drawn up for all claims

| Place of search | Date of completion of the search | Examiner |
|---|---|---|
| Munich | 25 July 2025 | Bergado Colina, J |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
...........................................................................
& : member of the same patent family, corresponding document

EPO FORM 1503 03.82 (P04C01)

Europäisches
Patentamt

European
Patent Office

Office européen
des brevets

**EUROPEAN SEARCH REPORT**

**Application Number**

EP 25 16 0959

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | DE 10 2012 107021 B4 (HINKE ROLAND [DE]) 30 October 2014 (2014-10-30) * abstract * * paragraph [0093] - paragraph [0131]; figures 1-10 * | 1-12 | |
| A | US 2019/245340 A1 (PORTER DAVID GLENN [US]) 8 August 2019 (2019-08-08) * abstract * * paragraph [0013] - paragraph [0029]; figures 1-3 * | 1-12 | |
| A | RADIL T ET AL: "PQ Monitoring System for Real-Time Detection and Classification of Disturbances in a Single-Phase Power System", IEEE TRANSACTIONS ON INSTRUMENTATION AND MEASUREMENT, IEEE, USA, vol. 57, no. 8, 1 August 2008 (2008-08-01), pages 1725-1733, XP011227743, ISSN: 0018-9456, DOI: 10.1109/TIM.2008.925345 * the whole document * | 1-12 | |
| | | | TECHNICAL FIELDS SEARCHED (IPC) |
| A | US 2011/213577 A1 (MOUSAVI MIRRASOUL [US] ET AL) 1 September 2011 (2011-09-01) * abstract * * paragraph [0022] - paragraph [0055]; figures 1-8 * | 1-12 | |

The present search report has been drawn up for all claims

| Place of search | Date of completion of the search | Examiner |
|---|---|---|
| Munich | 25 July 2025 | Bergado Colina, J |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 3 of 3

## ANNEX TO THE EUROPEAN SEARCH REPORT
## ON EUROPEAN PATENT APPLICATION NO.

EP 25 16 0959

This annex lists the patent family members relating to the patent documents cited in the above-mentioned European search report.
The members are as contained in the European Patent Office EDP file on
The European Patent Office is in no way liable for these particulars which are merely given for the purpose of information.

25-07-2025

| Patent document cited in search report | | Publication date | Patent family member(s) | | Publication date |
|---|---|---|---|---|---|
| CN 116908569 | A | 20-10-2023 | NONE | | |
| CN 103439569 | B | 20-01-2016 | NONE | | |
| CN 113030616 | A | 25-06-2021 | NONE | | |
| CN 106443164 | B | 29-11-2019 | NONE | | |
| CN 107462764 | A | 12-12-2017 | NONE | | |
| DE 102012107021 | B4 | 30-10-2014 | NONE | | |
| US 2019245340 | A1 | 08-08-2019 | US 2019245340 A1 | | 08-08-2019 |
| | | | WO 2019168586 A1 | | 06-09-2019 |
| US 2011213577 | A1 | 01-09-2011 | CN 102016607 A | | 13-04-2011 |
| | | | EP 2269080 A1 | | 05-01-2011 |
| | | | US 2011213577 A1 | | 01-09-2011 |
| | | | WO 2009120765 A1 | | 01-10-2009 |

EPO FORM P0459

For more details about this annex : see Official Journal of the European Patent Office, No. 12/82